(19) Europäisches Patentamt / European Patent Office / Office européen des brevets

(11) **EP 3 369 701 A1**

(12) **EUROPEAN PATENT APPLICATION**

(43) Date of publication:
05.09.2018 Bulletin 2018/36

(51) Int Cl.:
***B81B 7/00*** (2006.01)

(21) Application number: 18155418.9

(22) Date of filing: 06.02.2018

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(30) Priority: 03.03.2017 GB 201703464

(71) Applicant: **Atlantic Inertial Systems Limited**
**Plymouth, Devon PL6 6DE (GB)**

(72) Inventor: **MALVERN, Alan**
**Plymouth, Devon PL6 7SN (GB)**

(74) Representative: **Dehns**
**St. Brides House**
**10 Salisbury Square**
**London EC4Y 8JD (GB)**

(54) **VIBRATION DAMPING MOUNT**

(57) A MEMS sensor package comprises a MEMS sensor (4) that is fixed to a vibration damping mount (2). The mount (2) comprises a silicon substrate defining an outer frame (8) and a moveable support (6) to which the MEMS sensor (4) is fixed. A vibration damping structure (12, 14, 16) is connected between the outer frame (8) and the moveable support (6) to damp movement of the support (6). The MEMS sensor (4) and vibration damping mount (2) are enclosed by a casing (10) that is backfilled with gas.

Fig. 1

## Description

The present disclosure relates to a vibration damping mount for a MEMS sensor.

Microelectromechanical systems (MEMS) sensors, typically fabricated from a single silicon wafer, can be used to measure linear or angular motion without a fixed point of reference. MEMS gyroscopes, or strictly speaking MEMS angular rate sensors, can measure angular rate by observing the response of a vibrating structure to Coriolis force. MEMS accelerometers can measure linear acceleration by observing the response of a proof mass suspended on a spring. Typically an Inertial Measurement Unit (IMU) package contains one or more gyroscopes and/or accelerometers - for example an IMU may contain three gyroscopes and three accelerometers such that the IMU can detect angular rates around and linear accelerations in each of the x-, y-, and z-axes. Each MEMS sensor in an IMU package is normally supported by an elastomeric mount that sits between the IMU package and the MEMS substrate. The mount has two main functions: to provide isolation from unwanted external vibrations; and to absorb mechanical stress due to thermal expansion differences between the IMU package and the substrate. The IMU package itself may also be mounted to an elastomeric damper in an effort to isolate itself from external influences.

However, current elastomer mounts for MEMS sensors do not give critical damping and suffer from long term ageing. It is important to reduce the external vibration felt by a MEMS sensor using critical damping so that vibration rectification error (VRE) is minimised for both gyroscopes and accelerometers. Elastomeric materials such as silicone can suffer from long term creep or deformation over time. This results in poor control over the angular stability of the MEMS sensors in the IMU package, meaning that alignment of each MEMS sensor relative to the package substrate is difficult to maintain during the operating life of the IMU. Misalignment causes bias shifts for MEMS sensors such as accelerometers and gyroscopes. This long term creep can also change the stress state of the sensor which can give rise to bias and scale factor shifts.

It is known to load an elastomeric sensor mount with small solid balls having a diameter similar to the thickness of the elastomer layer, which helps to maintain alignment. However, this tends to disrupt the anti-vibration action of the mount, as when the MEMS sensor is grounded on the balls there is no vibration isolation as motion is transmitted through the solid balls.

US 8,896,074 discloses a MEMS vibration isolation system configured to decouple an IMU package or module from external shock and vibration. The vibration isolation system is etched from a silicon substrate and configured to use squeeze film damping to critically damp externally-imparted vibrations that may otherwise affect measurements made by the accelerometer(s), gyroscope(s) and/or magnetometer(s) inside the package.

The Applicant has recognised that the relative alignment of the MEMS sensors within an IMU package needs to be maintained to high accuracy for a high performance IMU, and this requires a new approach to vibration damping at the sensor level. For example, misalignment between the individual MEMS gyroscopes in a package means that rotation about one axis will cause signals to be measured on other axes too. Similarly, misalignment between the individual accelerometers in a package means that accelerations in one axis will cause signals to be measured in other axes too. Normally, any raw misalignment of sensors is corrected during IMU calibration. However, if misalignment is created over time due to stress effects on the elastomeric sensor mounts then the accuracy of the IMU will deteriorate during operation.

There remains a need for improved vibration damping mounts for MEMS sensors.

According to the present disclosure there is provided a MEMS sensor package comprising a MEMS sensor fixed to a vibration damping mount, the mount comprising a silicon substrate defining:

an outer frame;
a moveable support to which the MEMS sensor is fixed; and
a vibration damping structure connected between the outer frame and the moveable support to damp movement of the support;
wherein the MEMS sensor and vibration damping mount are enclosed by a casing that is backfilled with gas.

Such a MEMS sensor package provides a new approach to anti-vibration mounting at the sensor level by packaging a MEMS sensor in the same outer casing as a vibration damping mount formed from a silicon substrate. It will be recognised that such a vibration damping mount is itself a MEMS structure and can thus be fabricated at wafer level, where many of the parts can be formed at the same time. The MEMS sensor and vibration damping mount may both be fabricated as silicon-on-glass (SOG) structures which are fixed together before being enclosed by the same casing to form the sensor package. The MEMS sensor package may take the form of a single chip with its own internal vibration damping for the MEMS sensor. A benefit of this arrangement is that the vibration damping mount can physically decouple the MEMS sensor from the casing, acting to absorb vibrations experienced by the package, but without the use of conventional elastomeric damping materials. Furthermore, as will be discussed in more detail below, the vibration damping structure can be arranged to provide an isotropic damping response. For example, critical damping may be achieved for movement in the x-, y- and z-directions, and the resonant frequencies of the support in all three directions can preferably be matched.

In a set of example the MEMS sensor package comprise a further vibration damping structure arranged to damp movement of the support out of the plane of the outer frame. This further vibration damping structure may be provided specifically to respond to motions in the z-direction. Preferably the further vibration damping structure comprises a plurality of apertures extending through the moveable support in a direction out of its plane. Such apertures may extend substantially in the z-direction out of the plane of the moveable support or such apertures may be angled, for example at an angle θ relative to the plane of the moveable support, where $0 < θ \leq 90°$.

In a preferred set of examples the number and/or size of the apertures is chosen to provide critical damping. For example, apertures having a size of the order of 10 microns may be chosen. The apertures may have any suitable shape, for example circular, ellipsoidal, rectangular, and a variety of different shapes may be used as appropriate. The apertures may take the form of holes or slots extending through the moveable support.

The Applicant has recognised that the vibration damping structure connected between the outer frame and the moveable support has an important function for decoupling the moveable support from the outer frame, especially when the outer frame is touching, or fixed to, the casing. The casing is subject to packaging stress and variable stresses transmitted to the moveable support, and hence to the MEMS sensor, which can detrimentally affect sensor alignment. In various examples of this disclosure, the MEMS sensor package comprises an outer frame that is fixed to the casing. All or part of the outer frame may be fixed to the casing.

In a preferred set of examples at least one of the outer frame and moveable support defined by the silicon substrate has a depth d, and the vibration damping structure comprises a support arrangement having a second depth that is less than the depth d. It has been found that thinning at least part of the vibration damping structure relative to the rest of the silicon structure allows for control over the stiffness and hence the damping effect. As will be described further below, this allows the resonant frequency of the support for out-of-plane motion (i.e. in the z-direction) to be set to be substantially equal to the in-plane resonant frequency (i.e. in the x- and y-directions).

This is considered novel and inventive in its own right for a vibration damping mount *per se*, and hence according to another aspect of the present disclosure there is provided a vibration damping mount for a MEMS sensor, the mount comprising a silicon substrate of depth d, the substrate defining:

> an outer frame;
> a moveable support for supporting a MEMS sensor; and
> a vibration damping structure connected between the outer frame and the moveable support to damp movement of the support;
> wherein the vibration damping structure comprises a support arrangement having a second depth that is less than the depth *d.*

The vibration damping structure may be etched or otherwise formed in the silicon substrate defining the outer frame and the moveable support. The Applicant has realised that it is important for the support arrangement of the vibration damping structure to provide "sway space" for the support, so that under the highest anticipated vibration levels a MEMS sensor mounted on the support does not touch down and damping is maintained. In order to achieve this, the stiffness of the support arrangement in the z-direction is reduced by making the second depth less than the depth d.

A typical MEMS sensor such as a vibrating structure gyroscope may typically experience an ambient vibration in the range of 20 Hz to 2 kHz (g rms). Ideally the vibration damping structure provides an isotropic response. A resonant frequency of e.g. 1 kHz for the support, preferably both in plane and out of plane, is a compromise frequency to give sufficient stiffness, but not too much so that the ambient vibration can be sensed by the MEMS sensor fixed to the support. Such a resonant frequency needs to give sufficient sway space so that under typical ambient vibration levels for an aircraft system (~8 g rms) there is no bump down of the support so that the mount remains effective.

The part of the vibration damping structure that is thinned to a depth < d, i.e. the support arrangement, preferably acts to carry the moveable support in a similar way to a spring. The second depth can be chosen to give a tailored degree of stiffness.

In a preferred set of examples the support arrangement comprises one or more compliant legs extending between the outer frame and the moveable support to damp movement of the support in the plane of the outer frame and/or out of the plane of the outer frame. These compliant legs are formed in the silicon substrate to have the second depth that is less than the depth d, for example by DRIE or other etching techniques. Preferably the support arrangement comprises a plurality of serpentine legs extending between the outer frame and the moveable support. Such serpentine legs may be folded back and forth in the same plane. This serpentine form is preferably realised such that each serpentine leg comprises at least a first generally straight section, a second generally straight section, and an end section of generally U-shaped form interconnecting the first and second generally straight sections, wherein the thickness of the end section is greater than the thickness of a central part of both of the first and second generally straight sections. The term "thickness" as used herein with reference to the serpentine legs refers to its x- and y-dimensions (i.e. in-plane thickness).

Such a support arrangement has been found to give a low resonant frequency $f_z$ (e.g. around 1 kHz) for the support and to help decouple thermally-induced strain. Preferably the vibration damping structure provides a resonant frequency $f_z$ for movement of the support out of the plane of the outer frame. The stiffness of the compliant legs may be chosen to provide a desired resonant frequency $f_z$, for example 1 kHz.

It has been found that legs which have a depth less than the depth $d$ of the substrate enable the resonant frequency $f_z$ out of the plane of the mount to be matched more easily to the resonant frequency $f_{xy}$ in the plane of the mount. For example, the legs may be thinned to a depth of 10-20 microns whereas the substrate may have a depth $d$ of around 100 microns. This facilitates an isotropic damping response in three dimensions. When the outer frame is fixed to a casing, the legs can absorb the mechanical stress of thermally-induced expansion/contraction that would otherwise affect the angular alignment of a MEMS sensor on the mount.

For ease of fabrication, the outer frame and/or the moveable support may also have a depth matching the depth $d$ of the substrate.

In addition to the compliant legs discussed above, or alternatively, the vibration damping structure may be arranged to provide a squeeze film damping effect. In a preferred set of examples the vibration damping structure comprises one or more sets of interdigitated fingers arranged to damp movement of the support in the plane of the outer frame. Each set of interdigitated fingers may comprise first fingers extending from the outer frame towards the moveable support and second fingers extending from the moveable support towards the outer frame, for example forming a comb-like structure. Preferably the first and second fingers are interdigitated alternately with an equal gap between each pair of first and second fingers. This helps to optimise the squeeze film damping effect.

As is known in the art, the spacings in this vibration damping structure, for example the gaps between the interdigitated fingers, can be chosen to provide a desired degree of in-plane squeeze film damping (i.e. in the x- and y-directions). Preferably the number and/or spacing of the one or more sets of interdigitated fingers is chosen to provide critical damping. For optimal performance, the depth of the interdigitated fingers preferably matches the depth $d$ of the substrate so that the volume of fluid being compressed/expanded therebetween is as large as possible. The interdigitated fingers may have the full height of the substrate to give as much in-plane damping as possible. In examples where the vibration damping structure comprises both compliant legs and interdigitated fingers, these two structures may be readily distinguished from one another by their depth out of the plane of the silicon substrate used to form the mount. Thus the fabrication process for the vibration damping structure may comprise two separate etching steps, the first being used to form in-plane features through the total depth $d$, and the second being used to thin the compliant legs, e.g. by backside etching of the silicon to a fraction of the whole depth $d$, such as to only 10 to 20 microns.

The gaps between the interdigitated fingers are set in accordance with the required in-plane resonant frequency $f_{xy}$ of the support. Furthermore, the in-plane gaps between the interdigitated fingers are preferably chosen such that there is no touchdown under typical vibration levels. For example, with an in-plane resonant frequency $f_{xy}$ of 1 kHz and a stiffness of 248 nm/g, with 6 micron gaps between the fingers, touchdown will occur at accelerations of around 24 g, which is in excess of typical g levels in aircraft which may be around 8 g rms (24 g peak). Thus with gaps of this size, there should not be any touchdown under normal vibration levels. Of course, under shock conditions touchdown may occur, but the mount will recover after the shock events, typically in less than a millisecond. In at least some examples, the one or more sets of interdigitated fingers have a finger spacing in the range of 5 to 10 microns, preferably about 6 microns.

The Applicant has appreciated the benefits of an isotropic damping response at the sensor level. Preferably the one or more sets of interdigitated fingers provide a resonant frequency $f_{xy}$ for movement of the support in the plane of the outer frame and the support arrangement is configured to provide a resonant frequency $f_z$ that substantially matches $f_{xy}$. For example, the compliant legs of the vibration damping structure may be thinned to provide a resonant frequency $f_z$ that substantially matches $f_{xy}$, e.g. both $f_{xy}$ and $f_z$ may be set at around 1 kHz. By effectively isolating each individual MEMS sensor from external vibrations, the relative alignment between sensors can be ensured regardless of thermally driven stress that may affect the overall IMU package.

In at least some examples the silicon substrate is anodically bonded to an underlying glass substrate.

In at least some examples of a MEMS sensor package, the outer frame is fixed to the casing.

In preferred examples, the MEMS sensor is at least one of a gyroscope or an accelerometer.

The MEMS sensor may be "open" or it may have its own casing back-filled with gas or evacuated. For example, if the MEMS sensor is a gyroscope, it may be open, while if the MEMS sensor is an accelerometer it may be hermetically sealed within its own, separate casing.

Preferably, the MEMS sensor has a bandwidth from DC to 500 Hz, 400 Hz, 300 Hz, or 200 Hz, and preferably a bandwidth from DC to at least 100 Hz in order to provide sensitivity to real world motion. The resonant frequency of the support can then be chosen accordingly (e.g. between 200 Hz and 2 kHz, such as 1 kHz as above). Of course, with critical damping there is effectively no resonance of the support and so this resonant frequency acts as the cut-off frequency of the effective low-pass filter provided by the support.

The present disclosure also extends to an Inertial Measurement Unit (IMU) comprising a plurality of the MEMS sensor packages disclosed herein.

An example of the present disclosure is described hereinbelow with reference to the accompanying drawings in which:

Fig. 1 is a plan view of a MEMS sensor package comprising a vibration damping mount for a MEMS sensor in accordance with the present disclosure;
Fig. 2 is a side sectional view of the MEMS sensor package of Fig. 1; and
Fig. 3 is a close-up view of a compliant leg in the vibration damping structure of the vibration damping mount of Fig. 1.

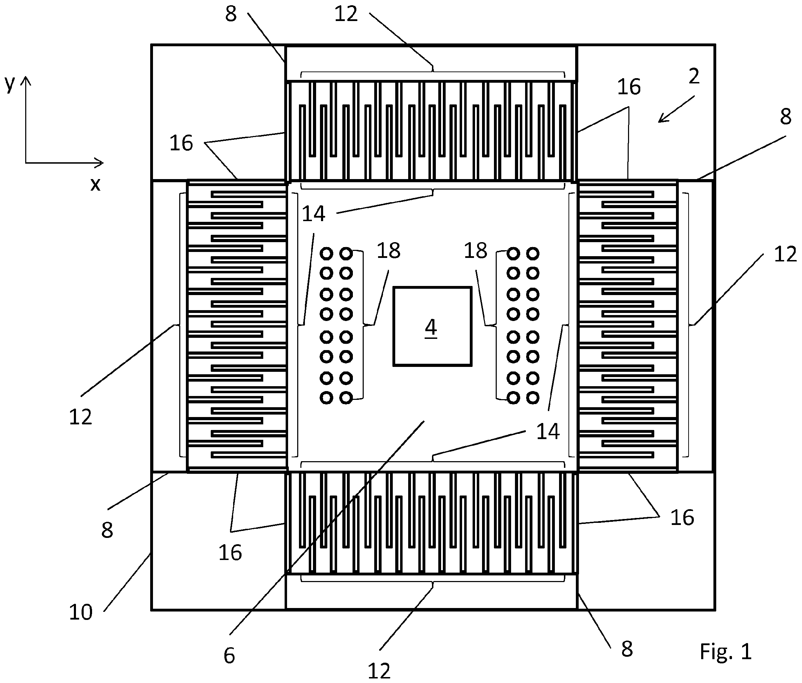

Fig. 1 is a plan view of a MEMS sensor package comprising a vibration damping mount 2 for a MEMS sensor 4 in accordance with the present disclosure. In this figure, the MEMS sensor 4 is shown as being mounted on the vibration damping mount 2; However, it should be appreciated that the MEMS sensor 4 does not form part of the vibration damping mount 2 itself. The x- and y-axes that will be referred to below are shown in the upper left corner of Fig. 1.

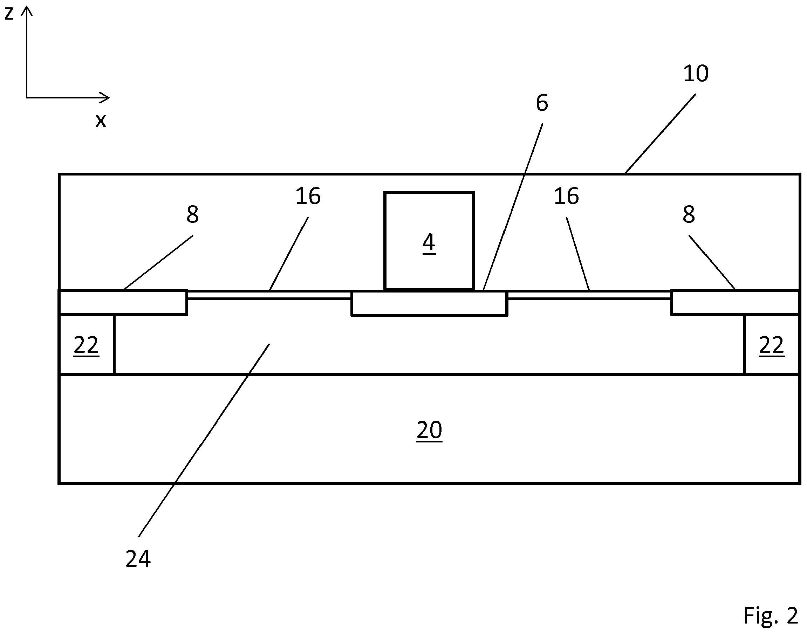

The vibration damping mount 2 comprises a movable support 6 onto which the MEMS sensor 4 is mounted and an outer frame 8, which are both formed from the same silicon substrate e.g. by deep reactive-ion etching (DRIE) or other known semiconductor fabrication techniques. The outer frame 8 is mounted to a base substrate as will be described with reference to Fig. 2 further below. The vibration damping mount 2 and the MEMS sensor 4 are enclosed by a casing 10 to form a hermetic package that is backfilled with air or a different gas such as argon or neon. As the vibration damping mount 2 and the MEMS sensor 4 are sealed within the same package casing 10, the MEMS sensor 4 can be "open" - i.e. the MEMS sensor 4 does not need to be sealed within its own package before mounting it on the moveable support 6, e.g. an inductive gyroscope. Otherwise, the MEMS sensor 4 may be sealed within its own hermetic package (e.g. a capacitive gyroscope in a vacuum or an accelerometer in a gas environment for squeeze film damping purposes), where this hermetic package is then fixed to the mount 2. The casing 10 of the overall MEMS sensor package therefore defines a sensor chip having its own internal vibration mounting.

The vibration damping mount 2 is arranged to isolate the MEMS sensor 4 from external vibrations in the x-, y-, and z-directions. In order to provide damping in the x- and y-directions, the vibration damping mount 2 comprises a first damping structure in the form of orthogonal sets of interdigitated fingers 12, 14 that provide squeeze film damping in the x- and y-directions. The outer frame 8 is provided with four arrays of fingers 12 that protrude from the frame 8 in the x- and y-directions towards the moveable support 6. As these fingers 12 protrude from the frame 8 which is fixed to the substrate (described with reference to Fig. 2), these fingers 12 are also fixed in position and do not move. However, the moveable support 6 is also provided with an array of fingers 14 that protrude from the moveable support 6 in the direction of the frame 8. The set of fingers 12 that protrude from the frame 8 and the set of fingers 14 that protrude from the moveable support 6 interdigitate with one another so as to provide a comb-like structure, preferably with an equal gap both sides to give as much squeeze film damping as possible. The set of fingers 14 that protrude from the moveable support 6 are able to move relative to the fixed fingers 12 when the vibration damping mount 2 undergoes acceleration, e.g. due to vibration. The interdigitated fingers 12, 14 are conveniently formed from the same silicon substrate as the outer frame 8 and moveable support 6.

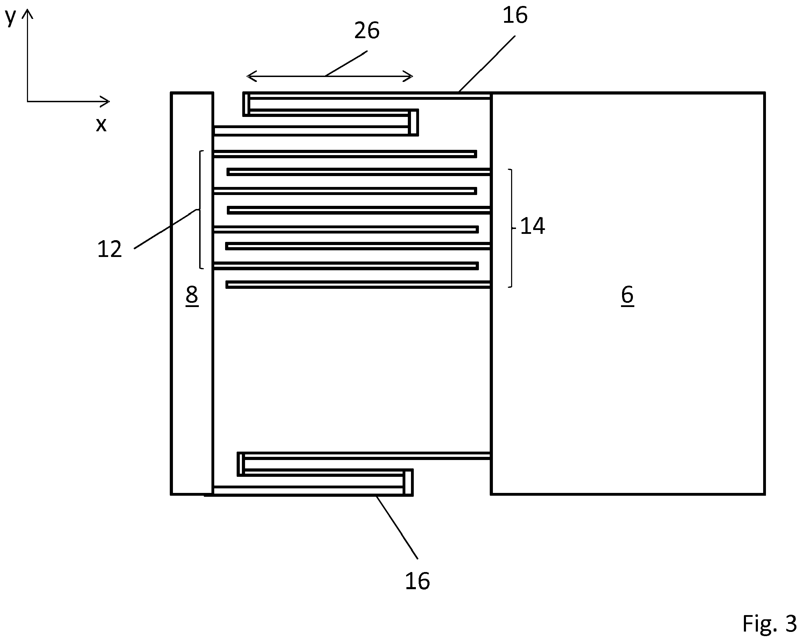

The moveable support 6 is connected to the outer frame 8 by a support arrangement comprising a number of compliant legs 16, that forms part of the first vibration damping structure. These compliant legs 16 act like springs and allow the moveable support 6 to move in the x-, y- and z-directions when the vibration damping mount 2 undergoes an acceleration, e.g. vibration. These legs 16 may be "serpentine" or "meandering" in structure as described further below with reference to Fig. 3. However, when the vibration damping mount 2 undergoes an acceleration in the x- or y-direction, the interdigitated fingers 12, 14 provide squeeze film damping that reduces the magnitude of motion of the moveable support 6. The squeeze film damping effect arises due to gas (e.g. air, argon, neon, etc.) between the fingers 12 attached to the frame 8 and the fingers 14 connected to the moveable support 6 being compressed as the gap between adjacent fingers 12, 14 is reduced when the moveable support 6 moves.

The vibration damping mount 2 is also arranged to isolate the MEMS sensor 4 from vibrations in the z-direction using a second vibration damping structure. This is described in further detail with reference to Fig. 2, however it should be noted that the moveable support 6 comprises an array of apertures 18 that extend through the support 6 in the z-direction and contribute to the z-direction damping characteristics of the vibration damping mount 2 that are more clearly visible in the plan view of Fig. 1 than the side view of Fig. 2.

Fig. 2 is a side sectional view of the vibration damping mount 2 of Fig. 1. It can be seen in Fig. 2 that the silicon structure comprising the moveable support 6, the outer frame 8, the interdigitated fingers 12, 14, and the compliant legs 16 is anodically bonded to a glass substrate 20. A spacing layer 22 separates the frame 8 (and thus the moveable support 6 which is connected to the frame 8 via the compliant legs 16) from the glass substrate 20 thus providing a cavity 24 between the glass substrate 20 and the moveable support 6, the frame 8, and the compliant legs 16. This cavity 24 provides a "bump stop" that sets a limit on how far the moveable support 6 can move when the vibration damping mount 2 undergoes an acceleration in the z-direction, where the size of the bump stop can be set by choosing an appropriate size of the spacing layer 22, e.g. 10-20 microns. In addition, one or more bump stop protrusions may be located in the cavity 24. The x- and z-axes are shown in the upper left corner of Fig. 2.

The frame 8 is fixed to the sides of the hermetic package casing 10 such that vibrations applied to the casing 10 are absorbed by the vibration damping mount 2. The compliant legs 16 effectively decouple the moveable support 6 from the frame 8 and, by extension, the hermetic package casing 10. Thus unwanted vibrations applied to the MEMS sensor package have minimal impact on the moveable support 6 and hence the MEMS sensor 4 mounted on the moveable support 6.

As can be seen schematically in Fig. 2, the compliant legs 16 are "thinned" in the z-direction compared to the frame 8 and the support 6. While the interdigitated fingers 12, 14 are the same thickness d as the frame 8 and the moveable support 6 respectively, the compliant legs 16 are substantially thinner than the frame 8 and the moveable support 6. For example, the frame 8, the moveable support 6, and the interdigitated fingers 12, 14 may have a thickness of around 100 microns while the compliant legs 16 may have a thickness of only 10-20 microns. The thickness of the compliant legs 16 sets the resonant frequency $f_z$ of the support 6 in the z-direction in conjunction with the carried mass of the support 6 and the MEMS sensor 4. Ideally, the resonant frequency $f_z$ in the z-direction is the same as the resonant frequency $f_{xy}$ in the x- and y-directions. The ideal value of these resonant frequencies $f_{xy}$ and $f_z$ will depend on the requirements of the MEMS sensor 4, however a typical MEMS sensor such as a vibrating structure gyroscope or accelerometer may have an operational input vibration spectrum of 20 Hz to 2 kHz (g rms) with an operational bandwidth of $\geq$100 Hz, and typically $\geq$200 Hz. A suitable value for the resonant frequencies $f_{xy}$ and $f_z$ may therefore be, by way of example only, 1 kHz as this frequency may provide an acceptable compromise so as to provide sufficient stiffness without absorbing too much ambient vibration and giving fidelity of the low frequency vibration signals. Accordingly, low frequency vibrations, for example up to 200 Hz, will not be filtered out by the compliant legs 16 and thus will be passed to the MEMS sensor 4. This is important as it allows accelerations and vibrations within the bandwidth of the MEMS sensor 4 to be detected and recorded correctly.

Ideally, the damping ratios $\zeta_x$, $\zeta_y$ and $\zeta_z$ in the x-, y-, and z-directions respectively are the same, i.e. the vibration damping mount 2 provides isotropic damping such that $\zeta_x = \zeta_y = \zeta_z$.

The undamped resonant frequencies can be determined using the relationship $f_0 = \frac{1}{2\pi}\sqrt{\frac{k}{m}}$ where $f_0$ is the undamped resonant frequency, $k$ is the stiffness of the damping structure, and $m$ is the carried mass. The resonant frequencies are typically set during design using finite element modelling methods, known in the art *per se,* taking account of the carried mass and the elastic properties of the silicon. Thus, it is important to account for the mass of the MEMS sensor 4 when designing the vibration damping mount 2.

The geometry of the vibration damping mount 2 is preferably selected such that the moving parts (i.e. the moveable support 6 and the corresponding fingers 14) do not "touchdown" under typical ambient vibration levels. For example, if the vibration damping mount 2 is to be used in aerospace applications, the geometry of the vibration damping mount 2 may need to accommodate accelerations of around 8 g rms without the moveable support 6 touching the glass substrate 20 or the moveable fingers 14 touching the fixed fingers 12.

The MEMS sensor 4 is typically fixed to the moveable support 6 using, by way of example only, a thin epoxy layer (e.g. 5 microns thick) or using Si-Si fusion bonding. Alternatively, the MEMS sensor 4 may be fixed to the moveable support 6 using eutectic bonding (e.g. using a Ag-Sn alloy), glass frit bonding (sometimes referred to as glass soldering) or any other suitable bonding method known in the art *per se.* Although not seen in Fig. 2, the support 6 also provides electrical interconnects for the MEMS sensor 4.

While the damping ratios $\zeta_x$, $\zeta_y$ in the x- and y-directions can be set by choosing an appropriate gap between adjacent interdigitated fingers 12, 14, it can be more difficult to control the damping ratio $\zeta_z$ in the z-direction. The apertures 18 referred to previously with reference to Fig. 1 provide a mechanism for controlling the magnitude of the squeeze film damping in the z-direction and thus the damping ratio $\zeta_z$ in the z-direction. Ideally, the number, placement, size, and density of these apertures 18 are selected so as to provide critical damping in the z-direction. Similarly, the size of the gaps between adjacent fingers 12, 14 is also selected in order to provide critical damping in the x- and y-directions (i.e. $\zeta_x = \zeta_y = 1$). While the apertures 18 shown in Fig. 1 are circular holes, it will be appreciated that other shapes may be used for the apertures 18, for example ellipsoidal or rectangular holes or slots may be used instead, or a variety of different shapes including irregular shapes may be used as appropriate.

Fig. 3 is a close up view of a compliant support leg 16 in the support arrangement of the vibration damping mount 2 of Fig. 1. As it can be seen from Fig. 3, the compliant support legs 16 are not simply a straight beam connecting the outer frame 8 to the moveable support 6, but instead have a serpentine form that allows them to act as a spring connecting the moveable support 6 to the frame 8. Over a certain distance 26, the support leg 16 folds back and forth on itself to form a coil-like structure. Such serpentine legs are described in further detail in WO 2013/050752, the contents of which are hereby incorporated by reference. This serpentine form allows the leg 16 to be extended or compressed like a spring and thus permits motion of the moveable support 6 relative to the frame 8 in the x-, y- and z-directions when the vibration damping mount 2 experiences an acceleration in these directions (e.g. due to vibration). This serpentine form also allows the legs 16 to isolate the mount 2 and hence the MEMS sensor 4 from mechanical stresses due to thermal expansion rate mismatches. The legs 16 may carry metal tracking to provide an electrical connection to the moveable support 6 and therefore to the MEMS sensor 4 mounted thereon. The stiffness of the support arrangement is set by the number of these compliant legs 16, and a typical vibration damping mount 2 may have ten to twelve of these legs 16, for example with three legs 16 per "quarter" of the mount 2. Each leg 16 may carry a conductive track to convey electrical signals as required and the design can be adjusted so as to accommodate the number of tracks required for a particular application.

Although a single MEMS sensor 4 is shown, it will be appreciated that more than one sensor may be fixed to the mount 6, e.g. a gyroscope and one or two accelerometers (such as a pair of x- and a y-direction accelerometers and a gyroscope arranged to measure angular rate in the x-y plane) or two accelerometers (e.g. to measure accelerations in the x- and y-directions). For example, the Gemini™ system manufactured by Silicon Sensing® provides a dual-axis MEMS accelerometer that may be fixed to the mount 6. Where multiple sensors are fixed to the mount 6, each sensor may be sealed in its own hermetic package or may be open, and a mix of open and sealed sensors may be mounted within the same MEMS sensor package.

Thus it will be seen that a vibration damping mount for a MEMS sensor that provides critical damping in the x-, y-, and z-directions has been described herein. Although particular examples have been described in detail, it will be appreciated by those skilled in the art that many variations and modifications are possible using the principles of the disclosure set out herein.

**Claims**

1. A MEMS sensor package comprising a MEMS sensor fixed to a vibration damping mount, the mount comprising a silicon substrate defining:

    an outer frame;
    a moveable support to which the MEMS sensor is fixed; and
    a vibration damping structure connected between the outer frame and the moveable support to damp movement of the support;
    wherein the MEMS sensor and vibration damping mount are enclosed by a casing that is backfilled with gas.

2. A MEMS sensor package according to claim 1, comprising a further vibration damping structure arranged to damp movement of the support out of the plane of the outer frame.

3. A MEMS sensor package according to claim 1 or 2, wherein the further vibration damping structure comprises a plurality of apertures extending through the moveable support in a direction out of its plane.

4. A MEMS sensor package according claim 3, wherein the number and/or size of the apertures is chosen to provide critical damping.

5. A MEMS sensor package according to any preceding claim, wherein at least one of the outer frame and moveable support defined by the silicon substrate has a depth d, and the vibration damping structure comprises a support arrangement having a second depth that is less than the depth d.

6. A vibration damping mount for a MEMS sensor, the mount comprising a silicon substrate of depth d, the substrate defining:

    an outer frame;
    a moveable support for supporting a MEMS sensor; and
    a vibration damping structure connected between the outer frame and the moveable support to damp movement of the support;
    wherein the vibration damping structure comprises a support arrangement having a second depth that is less than the depth d.

7. A MEMS sensor package or a vibration damping mount according to claim 5 or 6, wherein the support arrangement comprises one or more compliant legs extending between the outer frame and the moveable support to damp movement of the support in the plane of the outer frame and/or out of the plane of the outer frame.

8. A MEMS sensor package or a vibration damping mount according to claim 7, wherein the compliant legs comprise a plurality of serpentine legs extending between the outer frame and the moveable support.

9. A MEMS sensor package or a vibration damping mount according to any preceding claim, wherein the support arrangement provides a resonant frequency $f_z$ for movement of the support out of the plane of the outer frame.

10. A MEMS sensor package or a vibration damping mount according to claim 9, wherein $f_z$ is about 1 kHz.

11. A MEMS sensor package or a vibration damping mount according to any preceding claim, wherein the vibration damping structure comprises one or more sets of interdigitated fingers arranged to damp movement of the support in the plane of the outer frame.

**12.** A MEMS sensor package or a vibration damping mount according to claim 11, wherein the number and/or spacing of the one or more sets of interdigitated fingers is chosen to provide critical damping.

**13.** A MEMS sensor package or a vibration damping mount according to claim 11 or 12, wherein the one or more sets of interdigitated fingers provide a resonant frequency $f_{xy}$ for movement of the support in the plane of the outer frame and the support arrangement is configured to provide a resonant frequency $f_z$ for movement of the support out of the plane of the outer frame that substantially matches $f_{xy}$.

**14.** A MEMS sensor package or a vibration damping mount according to any preceding claim, wherein the silicon substrate is anodically bonded to an underlying glass substrate.

Fig. 1

EP 3 369 701 A1

Fig. 2

Fig. 3

Europäisches
Patentamt

European
Patent Office

Office européen
des brevets

# EUROPEAN SEARCH REPORT

Application Number

EP 18 15 5418

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 8 896 074 B2 (BERNSTEIN JONATHAN [US]; WEINBERG MARC [US]; DRAPER LAB CHARLES S [US]) 25 November 2014 (2014-11-25) | 1,2 | INV. B81B7/00 |
| A | * figures 1A-2B,4A,4B,5 * | 3-14 | |
| X | US 9 250 262 B1 (DESAI HEMANT [US] ET AL) 2 February 2016 (2016-02-02) * figures 1,2 * | 6-14 | |
| X | KR 100 548 200 B1 (SAMSUNG ELECTRONICS CO LTD [KR]) 2 February 2006 (2006-02-02) | 6 | |
| A | * figures 2,3 * | 5,7-14 | |
| X | US 2012/130671 A1 (HORNING ROBERT D [US] ET AL) 24 May 2012 (2012-05-24) * figures 2-4 * | 1 | |
| X | US 2003/038415 A1 (ANDERSON RICHARD S [US] ET AL) 27 February 2003 (2003-02-27) * figures 5,7-11 * | 1 | |

TECHNICAL FIELDS
SEARCHED (IPC)

B81B

The present search report has been drawn up for all claims

| Place of search | Date of completion of the search | Examiner |
|---|---|---|
| Berlin | 29 June 2018 | McGinley, Colm |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 15 5418

This annex lists the patent family members relating to the patent documents cited in the above-mentioned European search report.
The members are as contained in the European Patent Office EDP file on
The European Patent Office is in no way liable for these particulars which are merely given for the purpose of information.

29-06-2018

| Patent document cited in search report | | | Publication date | Patent family member(s) | | Publication date |
|---|---|---|---|---|---|---|
| US | 8896074 | B2 | 25-11-2014 | US 2013194770 A1<br>WO 2013112310 A2 | | 01-08-2013<br>01-08-2013 |
| US | 9250262 | B1 | 02-02-2016 | NONE | | |
| KR | 100548200 | B1 | 02-02-2006 | NONE | | |
| US | 2012130671 | A1 | 24-05-2012 | CN 102530827 A<br>EP 2455329 A2<br>JP 5860270 B2<br>JP 2012146958 A<br>US 2012130671 A1 | | 04-07-2012<br>23-05-2012<br>16-02-2016<br>02-08-2012<br>24-05-2012 |
| US | 2003038415 | A1 | 27-02-2003 | US 2003038415 A1<br>US 2005258525 A1 | | 27-02-2003<br>24-11-2005 |

EPO FORM P0459

For more details about this annex : see Official Journal of the European Patent Office, No. 12/82

**EP 3 369 701 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8896074 B
- WO 2013050752 A